# EUROPEAN PATENT APPLICATION

(11) **EP 4 799 923 A1**
(43) Date of publication of application: **02.09.2026**
(21) Application number: 26158101.1
(22) Date of filing: 12.02.2026
(51) Int. Cl.: B64C 9/18, B64C 9/22, B64C 9/24, B64C 13/16

(54) **HIGH LIFT SYSTEM ARCHITECTURE, ASSOCIATED HIGH LIFT SYSTEM, AIRCRAFT AND METHOD OF OPERATING A HIGH LIFT SYSTEM ARCHITECTURE**

(30) Priority: 27.02.2025 DE 102025000716
(71) Applicant: Airbus Operations GmbH, 21129 Hamburg (DE)
(72) Inventor: Haserodt, Jan, 21129 Hamburg (DE)
(74) Representative: Airbus Germany

(57) **Abstract**

This high lift system architecture (22) comprises:
- an actuation arrangement (24), configured to move at least one moveable surface (20);
- a sensor (26), configured to generate an analog sensed signal representative of a configuration of the moveable surface (20);
- a flight control computer (28); and
- an actuation control device (30) comprising:
+ an acquisition module (42) for acquiring the analog sensed signal,
+ a processing module (44) for processing the analog sensed signal and for generating an analog controlling signal based on the processed analog sensed signal,
+ a conversion module (46) for converting the analog sensed signal into a digitalized monitoring signal,
+ a control module (48) for controlling the actuation arrangement (24) based on the generated analog controlling signal, and

+ a communication module (50) for communicating the digitalized monitoring signal to the flight control computer (28)

## Description

The present disclosure relates to a high lift system architecture. The present disclosure further relates to a high lift system comprising such a high lift system architecture. The present disclosure also relates to an aircraft comprising a high lift system as above mentioned. The present disclosure further relates to a method of operating a high lift system architecture as above mentioned.

**In** the domain of high lift system architectures, one knows using architectures in which sensors of high lift systems are connected to a flight control computer. In such architectures, sensors are configured for sending analog sensed signal to the flight control computer, such that the flight control computer processes this signal. Based on the flight control computer processing of the analog sensed signal, the flight control computer is for example configured to control the high lift system.

Such architecture is however not entirely satisfying. Indeed, in such architectures, the flight control computer needs to process information very quickly in order to control the high lift system properly. Furthermore, such architecture relies on a centralized processing of the data at the flight control computer. Considering the high number of sensors, it can be difficult to properly connect all sensors to the flight control computer.

An object of the present invention is therefore to provide a high lift system architecture which allows a fast enough controlling of the high lift system and also allows an easy integration of a high number of sensors.

To this end, the invention relates to a high lift system architecture for an aircraft, comprising:
- an actuation arrangement, configured to move at least one moveable surface of the aircraft between a stowed and a deployed configuration;
- a sensor, configured to generate an analog sensed signal representative of a configuration of the moveable surface;
- a flight control computer; and
- an actuation control device, connected to the actuation arrangement, to the sensor and to the flight control computer, the actuation control device comprising:
   + an acquisition module, configured for acquiring the analog sensed signal from the sensor,
   + a processing module, configured for processing the analog sensed signal and for generating an analog controlling signal based on the processed analog sensed signal,
   + a conversion module, configured for converting the analog sensed signal into a digitalized monitoring signal,
   + a control module, configured for controlling the actuation arrangement based on the generated analog controlling signal, and
   + a communication module, configured for communicating the digitalized monitoring signal to the flight control computer.

The use of an actuation control device comprising an acquisition module, a processing module, a conversion module, a control module and a communication module as presented above is especially advantageous since this allows for processing operations not to happen at the flight control computer level but at the actuation control device level. This ensures a quick enough processing since data does not need to be carried and/or converted to the flight control computer before processing. Furthermore, the digitalization of the analog sensed signal in the actuation control device allows for example communication with the flight control computer through a data bus, without having lag issues for critical processing of the analog sensed signal, which is processed directly in the actuation control device.

According to other advantageous aspects of the invention, the high lift system architecture comprises one or more of the following features taken alone or according to all technically possible combinations:
- the actuation arrangement comprises a motor and an actuator connected to the motor, the actuator being configured for converting movement of the motor to a movement of the at least one moveable surface,
   the control module being configured for controlling the motor and/or the actuator based on the generated analog controlling signal;
- the actuation arrangement comprises a plurality of motors and a plurality of actuators, the high lift system architecture further comprising a plurality of actuation control devices, each actuation control device being connected to one of the plurality of motors and/or to one of the plurality of actuators, the control module of each actuation control device being configured for controlling said one of the plurality of motors and/or said one of the plurality of actuators based on the generated analog controlling signal;
- the processing module is configured for generating an analog controlling signal corresponding to a blocking signal, the control module being configured for controlling a blocking of the actuation arrangement based on the generated analog controlling signal;
- the actuation arrangement comprises at least one brake, configured for blocking movement of the at least one moveable surface,
   the control module being configured for controlling the at least one brake based on the generated analog controlling signal corresponding to a blocking signal;
- the brake is a power off brake, the generated analog controlling signal corresponding to a blocking signal being a power-off signal;
- the processing module is configured for generating an analog controlling signal corresponding to a blocking signal when the acquired analog sensed signal is representative of a skew of the high lift system;
- the sensor is part of an asymmetry position pick off unit, of a feedback position pick off unit, a wing tip brake unit and/or the actuation arrangement;
- the acquisition module is further configured for acquiring a command from the flight control computer, the control module being configured for sending the generated analog controlling signal to the actuation arrangement based on the acquired command;
- the communication module is configured to communicate a digitalized controlling signal representative of the generated analog controlling signal to the flight control computer; and
- the actuation control device comprises a first circuitry and a second circuitry, different from the first circuitry, at least one of the acquisition module, the processing module, the conversion module, the control module and the communication module being redundant and implemented on both the first and the second circuitry.

The invention further relates to a high lift system comprising a wing body, a moveable surface and a high lift system architecture as presented above.

According to an advantageous embodiment, the moveable surface of the high lift system is a slat.

The invention also relates to an aircraft comprising a high lift system as presented above.

The invention further relates to a method of operating a high lift system architecture as presented above, wherein the method comprises the following steps:
- acquiring an analog sensed signal from the sensor of the high lift system architecture;
- processing the analog sensed signal and generating an analog controlling signal based on the processed analog sensed signal;
- converting the analog sensed signal into a digitalized monitoring signal;
- controlling the actuation arrangement of the high lift system based on the generated analog controlling signal; and
- communicating the digitalized monitoring signal to the flight control computer of the high lift system architecture.

The invention will be better understood when reading the following description, which is given solely by way of example and with reference to the appended drawings, in which:
- Figure 1 is a schematic view of an aircraft comprising a high lift system with a high lift system architecture according to the invention;
- Figure 2 is a schematic representation of the high lift system architecture of the high lift system presented on figure 1;
- Figure 3 is a representation similar to the view of figure 2, of another high lift system architecture;
- Figure 4 is a schematic representation of an actuation control device of a high lift system architecture such as those illustrated on figures 2 and 3.

**In** this description, the term analog signal is understood as a signal that can be physically measured to obtain a value represented by such a signal, such as for example a voltage or an intensity, by opposition to a digital signal, which is understood as a signal comprising a series of digits which has to be interpreted to obtain a value represented by such a signal.

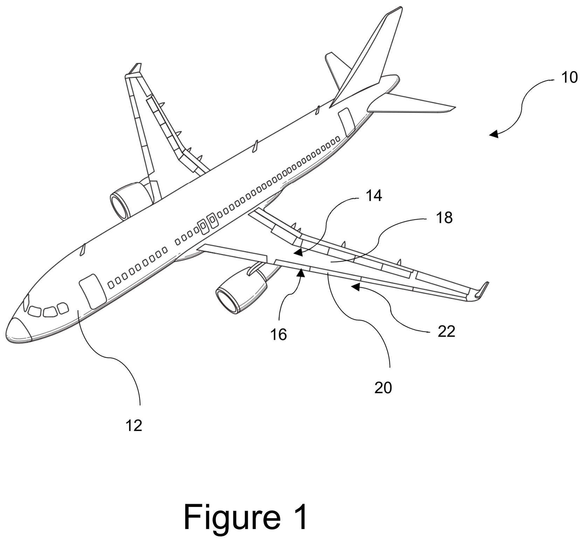

Referring to figure 1, an aircraft 10 comprises a fuselage 12 and wings 14.

The aircraft 10 is for example an airplane and is for example an airliner.

The aircraft 10 comprises a high lift system 16, for example arranged on the wings 14.

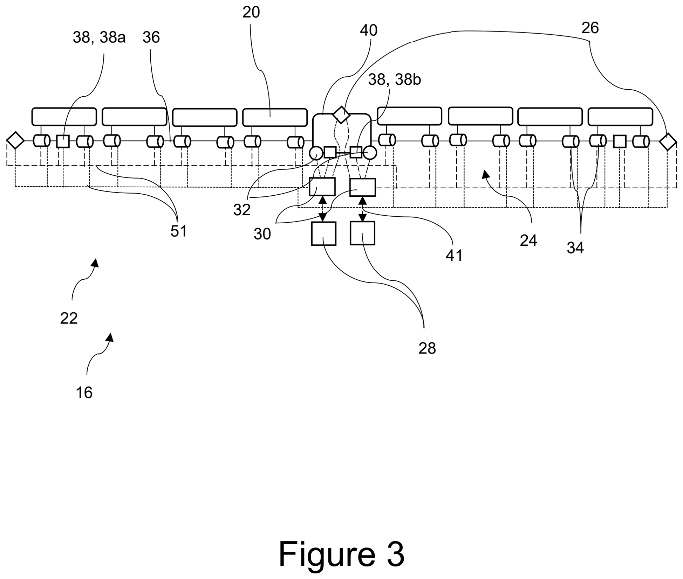

The high lift system 16 comprises in particular a wing body 18, a moveable surface 20 and a high lift system architecture 22. In the example illustrated on figures 1 and 3, the high lift system 16 comprises a plurality of moveable surfaces 20.

As visible from figure 1, the wing body 18 is for example a portion of the wing 14 which is fixed relative to the fuselage 12.

For example, and as visible from figures 1 to 3, the moveable surface 20 is a slat. In other words, in such an example, the high lift system 16 forms a leading edge high lift system/device.

**In** other non-illustrated example, the moveable surface 20 is a flap. **In** such an example, the high lift system 16 forms for example a trailing edge high lift system/device.

The moveable surface 20 is moveable relative to the wing body 18. For example, the moveable surface 20 is moveable between a stowed position and a deployed position the moveable surface 20 being further away from the wing body 18 when it is in its deployed position than when it is in its stowed position.

The high lift system architecture 22 is for example configured for actuating and controlling an actuation of the high lift system 16. In other words, the high lift system architecture 22 is for example configured for actuating and controlling the movement of the moveable surface 20 relative to the wing body 18.

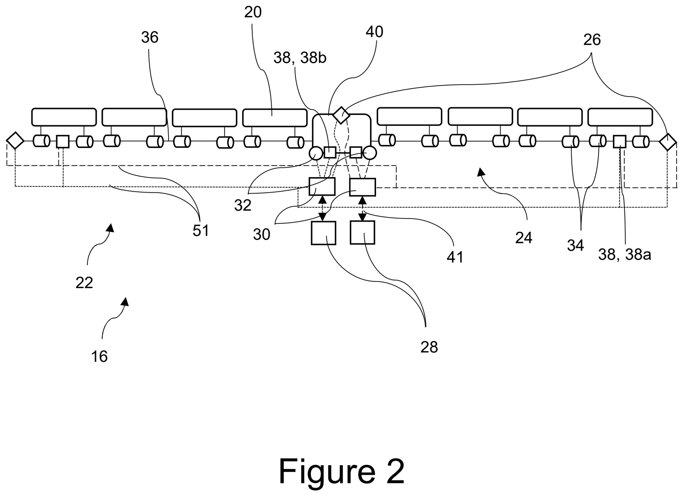

As illustrated in figures 2 and 3, the high lift system architecture 22 comprises an actuation arrangement 24, at least one sensor 26, a flight control computer 28 and an actuation control device 30.

The actuation arrangement 24 is configured to move at least one of the moveable surfaces 20 of the aircraft between its stowed and its deployed positions. For example and as illustrated in figures 1 to 3, the actuation arrangement 24 is configured to move a plurality of the moveable surfaces 20 of the aircraft, for example synchronously, between their stowed and deployed positions.

As illustrated in figures 2 and 3, the actuation arrangement 24 comprises for example a motor 32 and an actuator 34. The actuation arrangement 24 further comprises for example at least one transmission shaft 36. The actuation arrangement 24 further comprises for example at least one brake 38.

For example, the actuation arrangement 24 comprises a plurality of motors 32. In particular, in the example of figures 2 and 3, the actuation arrangement 24 comprises two motors 32. In particular, in this example, the two motors 32 are coupled to a Power Control Unit 40 (also abbreviated PCU) of the high lift system 16.

Each motor 32 is for example a hydraulic motor. In an example, each motor 32 is a redundant motor.

In a non-illustrated example, each motor 32 is an electric motor.

In the example of figures 2 and 3, the actuation arrangement 24 comprises a plurality of actuators 34.

Each actuator 34 is for example connected to the wing body 18 and to the moveable surface 20 and is for example configured for moving the moveable surface 20 relative to the wing body 18.

For example, and as illustrated in figures 2 and 3, the actuation arrangement 24 comprises two actuators for each moveable surface 20. In the illustrated example, the actuation arrangement 24 then comprises sixteen actuators.

Each actuator 34 is for example connected to the motor 32. In particular, when the actuation arrangement 24 comprises a plurality of motors 32, each actuator is connected to the plurality of motors 32 or is connected to one of the motors 32.

As illustrated in figures 2 and 3, each actuator 34 is for example connected to the, or one of the, motor(s), via the, or one of, the transmission shaft(s) 36.

Each actuator 34 is for example configured for converting a movement of the motor 32 to a movement of the at least one moveable surface 20.

For example, each actuator 34 is formed as a Geared Rotary Actuator (generally abbreviated GRA) and is configured for converting a rotational movement of the motor 32 to a deployment/retraction movement of the at least one moveable surface 20. Each actuator 34 is then for example configured to cooperate with a track (non represented), for example geared, of the moveable surface 20.

The at least one brake 38 is for example configured for braking and/or blocking the movement of the at least one moveable surface 20.

Each brake 38 is for example configured for braking the or one of the actuators 34 and/or the or one the motors 32 and/or the or one of the transmission shaft(s) 36.

Each brake 38 is for example a power off brake. In other words, each brake is configured for braking when it is not supplied with power, for example when it is not supplied with electrical current/voltage.

As understood from figures 2 and 3, the actuation arrangement 24 comprises for example a plurality of brakes 38. In particular, in this example, the brakes 38 are wing tip brakes 38A (generally abbreviated WTB) and motor brakes 38B.

The sensor 26 is configured to generate an analog signal representative of a configuration of the moveable surface 20, or in other word to sense such an analog signal.

The configuration of the movable surface corresponds for example to a position of the moveable surface 20 relative to the wing body 18 or to a load applied to the moveable surface 20.

In this description, the sensor 26 is a displacement sensor configured to generate an analog signal representative of a position of the moveable surface 20.

As visible from figures 2 and 3, the high lift system 16 comprises a plurality of such sensors 26 being displacement sensors.

The or each sensor 26 is for example part of an asymmetry position pick off unit (generally abbreviated APPU), of a feedback position pick off unit generally abbreviated FPPU), of a Wing Tip Brake unit and/or of the actuation arrangement 24.

In particular, in the example of figure 2, the high lift system architecture 22 comprises sensors 26 which are part of an asymmetry position pick off unit and sensors which are part of a feedback position pick off unit generally abbreviated FPPU).

In the example of figure 3, the high lift system architecture 22 comprises sensors 26 similar to those presented on figure 2 and further comprises sensors which are part of the actuation arrangement 24. In particular, the high lift system architecture 22 further comprises sensors arranged at each of the actuators 34. Each of these sensors 26 is for example configured for generating an analog signal representative of a position of each actuator 34 and/or of an effort applied at each actuator 34.

The flight control computer 28 is for example more particularly a Slat Flap Control Computer (generally abbreviated SFCC).

The flight control computer 28 is for example configured for controlling the high lift system 16, and more particularly the actuation arrangement 24, for example based on instructions received from a human machine interface (not represented) or of a further computer (not represented) of the aircraft 10.

As this will be presented in more details later on, the flight control computer 28 is for example configured for controlling the actuation arrangement 24 through the actuation control device 30.

To that end, the flight control computer 28 and the actuation control device 30 are for example connected via a databus 41 of the high lift system architecture 22, illustrated with arrows on figure 2 and 3. The flight control computer 28 and the actuation control device 30 are for example connected via a databus of type ARINC 629, ARINC 629 or ARINC 664 (also known as AFDX or Avionics Full-Duplex Switched Ethernet), ARINC standing for Aeronautical Radio Incorporated from Annapolis.

As visible from figure 2 and 3, the high lift system architecture 22 comprises for example two flight control computers 28, each flight control computer 28 being connected with a respective actuation control device 30.

It is then understood that in the example of figure 2 and 3, the high lift system architecture 22 comprises two actuation control devices 30. In other non-illustrated examples, the high lift system architecture comprises only one actuation control device 30 or more than two actuation control devices 30.

In particular, when the actuation arrangement 24 comprises a plurality of motors 32 and/or actuators 34, the high lift system architecture 22 comprises for example a plurality of actuation control devices 30, each actuation control device 30 being connected to one of the plurality of motors 32 and/or to one of the plurality of actuators 34.

As illustrated in figures 2 and 3, the actuation control device 30 is connected to the actuation arrangement 24, to the sensor 26 and to the flight control computer 28.

As presented above, the actuation control device 30 is for example connected to the control computer via a databus 41. The actuation control device 26 is further for example connected to the actuation arrangement 24 and to the sensor 26 via a connection cable 51, presented in more details later on.

For example, the actuation control device 30 acts as a motor control electronics, generally abbreviated MCE, for the high lift system 16.

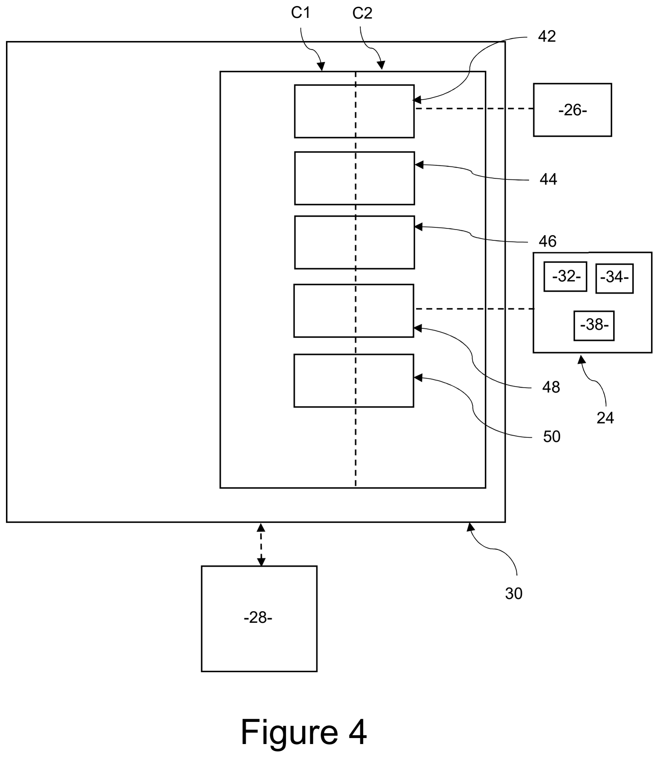

As illustrated in figure 4, the actuation control device 30 comprises an acquisition module 42, a processing module 44, a conversion module 46, a control module 48 and a communication module 50.

In an example, and as presented in more details later in this description, the actuation control device 30 comprises a first circuitry C1 and a second circuitry C2, different from the first circuitry C1.

For example, at least one of the acquisition module 42, of the processing module 44, of the conversion module 46, of the control module 48 and of the communication module 50 is redundant and implemented on both the first C1 and the second circuitry C2.

In particular, in the example illustrated in figure 4, the processing module 44, the conversion module 46, the control module 48 and the communication module 50 are redundant and implemented on both the first C1 and the second circuitry C2.

The acquisition module 42 is configured for acquiring an analog signal sensed from the sensor 26.

The acquisition module 42 is for example connected to the sensor 26 via a connection cable 51 of the high lift system architecture 22, illustrated with dashed lines on figures 2 to 4. The connection cable 51 is in particular configured for conducting the analog sensed signal generated by the sensor 26 to the acquisition module 42.

As illustrated in figures 2 and 3, the acquisition module 42 is for example connected to a plurality of sensors 26 via connection cables 51.

Furthermore, and for example, the acquisition module 42 is configured for acquiring a command from the flight control computer 28. The command is for example a digital command, directly acquired by the acquisition module 42. **In** alternative, the command is an analog command corresponding to a digital command emitted by the flight control computer 28 and converted by the conversion module 46. Further in alternative, the command is an analog command directly emitted by the flight control computer 28.

The processing module 44 is configured for processing the analog sensed signal, that is, the analog sensed signal acquired by the acquisition module 42. The processing module 44 is then further configured for generating an analog controlling signal based on the analog sensed signal.

The processing module 44 is thus preferably configured for processing the analog sensed signal into an analog controlling signal without digitalization of the analog sensed signal.

As this will be presented in more details later on, the processing module 44 is for example configured for generating an analog controlling signal corresponding to a blocking signal. One understands here that the processing module 44 is in particular configured for generating an analog controlling signal corresponding to a blocking signal depending on the processing of the acquired analog sensor signal.

As this will be presented later, the generated analog controlling signal corresponding to a blocking signal is in an example a signal corresponding to an absence of voltage/intensity. In other words, such a generated analog controlling corresponding to a blocking signal is a power-off signal.

For example, the processing module 44 is configured for generating an analog controlling signal corresponding to a blocking signal when the acquired analog sensed signal is representative of a skew of the high lift system.

For example, in the example of figure 2 or 3, the processing module 44 is configured for generating an analog controlling signal corresponding to a blocking signal when displacement at sensors part of the asymmetry position pick off unit, of the feedback position pick off unit or of the wing tip brake unit and/or of the actuation arrangement 24, are sensing an analog sensed signal representative of a non-nominal position of the moveable surface 20 relative to the wing body 18.

In the example of figure 3, and for example the processing module 44 is configured for generating an analog controlling signal corresponding to a blocking signal when the analog sensed signal of sensors 26 installed on two actuators connected to a same moveable surface 20 is representative of a skew of such a moveable surface 20, for example if an evolution of the displacement measured at these sensors is not synchronized.

The conversion module 46 is configured for converting the analog sensed signal into a digitalized monitoring signal.

In an example, the digital monitoring signal corresponds strictly to the analog sensed signal, and differs from the analog sensed signal only in that it takes a digital form.

In other examples, the digital monitoring signal is based on the analog signal. For example, the digital monitoring signal corresponds to an average of a plurality of analog sensed signal. Such plurality of analog sensed signal is for example sensed by a plurality of sensors and/or at different points in time.

As presented above, the conversion module 46 is in some examples further configured for converting a digital command emitted by the flight control computer 28 to an analog command, for example for the control module 48.

The control module 48 is configured for controlling the actuation arrangement 24 based on the generated analog controlling signal.

The control module 48 is for example connected to the motor 32 and/or to the actuator 34 and/or to the brake 38 via a connection cable 51 as above mentioned. The connection cable 51 is in particular configured for conducting the analog controlling signal to the motor 32 and/or to the actuator 34 and/or to the brake 38.

For example, and as above mentioned, in an example, the generated analog controlling signal corresponds to the absence of voltage/intensity of an electrical current, and in such an example, the control module 48 transmits for example the current or the absence of current to the actuation arrangement 24 further to the generation of the analog controlling signal.

In another example, the generated analog controlling signal is transmitted to the control module such that the control module 48 supplies, or not, the actuation arrangement depending on the generated analog controlling signal.

For example, the control module 48 is configured for controlling the motor 32 and/or the actuator 34 based on the generated analog controlling signal.

For example, the control module 48 is configured for stopping the motor 32 and/or the actuator 34 when the generated analog controlling signal corresponds to a blocking signal as presented above. For example, the control module 48 is configured for stopping the movement of the motor 32 and/or the actuator 34 by cutting power supply to the motor 32 and/or the actuator 34.

In alternative, or in complement, the control module 48 is configured for blocking the actuation arrangement 24 based on the generated analog controlling signal.

The control module 48 is for example configured for controlling the at least one brake 38 based on the generated analog controlling signal corresponding to a blocking signal.

For example, and as above mentioned, the at least one brake 38 is a power off brake. The control module 48 is then configured not to supply any electrical current to the at least one brake when the generated analog controlling signal corresponds to a blocking signal.

Furthermore, when the high lift system architecture 22 further comprises a plurality of actuation control devices 30, each actuation control device 30 is for example connected to one of the plurality of motors 32 and/or to one of the plurality of actuators 34 and/or to one of a plurality of brakes 38. Thus and in such a non-represented example, actuation control devices 30 are connected to different motors 32 and/or actuators 34 and/or to brakes 38.

In the example of figures 2 and 3, each motor 32, actuator 34 and to brake 38 is connected to both of the actuation control devices 30. As visible through the different dashed lines presented in figures 2 and 3, each actuation control devices 30 is for example connected to the motor 32, actuator 34 and brake 38 through a different arrangement of connection cables 51.

As presented above, the control module 48 is further for example configured for sending a generated analog controlling signal to the actuation arrangement based on a command acquired from the flight control computer 28.

The generated analog controlling signal is for example corresponding to a blocking signal as above mentioned when the command of the flight control computer 28 corresponds to a blocking command, for example, following a skew detection calculated from the flight control computer 28.

The communication module 50 is configured for communicating the digitalized monitoring signal to the flight control computer. In other words, the communication module 50 is in logical connection with the conversion module 46 such that the communication module 50 communicate the signal digitalized by the conversion module 46.

Furthermore, and for example, the communication module 50 is further configured for communicating a digitalized controlling signal representative of the analog controlling signal generated by the control module 48 to the flight control computer 28.

In the example of figure 4, the processing module 44, the conversion module 46, the control module 48 and/or the communication module 50 are each implemented as analog signal processing devices and as presented above, each of these devices is redundant and implement on each of the first C1 and second C2 circuits.

In a variant (not shown), the processing module 44, the conversion module 46, the control module 48 and/or the communication module 50 are each produced in the form of a programmable logic components, such as a FPGA (Field Programmable Gate Array), or in the form of a dedicated integrated circuit, such as an ASIC (Application Specific Integrated Circuit), or in the form of any combination of ASIC, FPGA and/or software.

In a further non illustrated example, the actuation control device 30 is formed as an information processing unit (non-represented) comprising, for example, a memory associated with a processor (non-represented).

In such an example, the processing module 44, the conversion module 46, the control module 48 and the communication module 50 are each produced in the form of software executable by the processor. The memory is then able to store an acquisition software, designed for acquiring an analog sensed signal from the sensor 26, a processing software, designed for processing the analog sensed signal and for generating an analog controlling signal based on the processed analog sensed signal, a conversion software, designed for converting the analog sensed signal into a digitalized monitoring signal, a control software, designed for controlling the actuation arrangement 24 based on the generated analog controlling signal and a communication software, designed for communicating the digitalized monitoring signal to the flight control computer 28.

The processor of the information processing unit is then able to execute the acquisition software, the processing software, the conversion software, the control software and the communication software.

When the actuation control device 30 is made in the form of one or several software programs, i.e., in the form of a computer program, it is further able to be stored on a medium, not shown, readable by computer. The computer-readable medium is for example a medium suitable for storing electronic instructions and able to be coupled with a bus of a computer system. As an example, the readable medium is an optical disc, a magnetic-optical disc, a ROM memory, a RAM memory, any type of non-volatile memory (for example, EPROM, EEPROM, FLASH, NVRAM), a magnetic card or an optical card. A computer program including software instructions is then stored on the readable medium.

A method of operating a high lift system architecture 22 as above described will now be presented.

In an acquiring step, an analog sensed signal is acquired from the sensor 26 of the high lift system architecture 22. In particular, the analog sensed signal is acquired by the acquisition module 42.

In a processing step, the analog sensed signal is processed and an analog controlling signal, based on the processed analog sensed signal, is generated. In particular, the analog sensed signal is processed by the processing module 44 and the analog controlling signal is generated by the processing module.

In a converting step, the analog sensed signal is converted into a digitalized monitoring signal. In particular, the analog sensed signal is converted into a digitalized monitoring signal by the conversion module 46.

In a controlling step, the actuation arrangement 24 of the high lift system 16 is controlled based on the generated analog controlling signal. In particular, the actuation arrangement is controlled by the control module 48.

In a communication step, the digitalized monitoring signal is communicated to the flight control computer 28 of the high lift system architecture 22. In particular, the digitalized monitoring signal is communicated by the communication module 50.

As presented above, the use of the above presented actuation control device 30 is especially advantageous allows for quick enough processing of the analogous sensed signal an limits the number of physical connections required to the flight control computer 28.

Having the control module 48 being configured for controlling the motor 32 and/or the actuator 34 based on the generated analog controlling signal is especially advantageous since this generated analog controlling is directly generated in the actuation control device 30. This ensures a quick control loop of the motor 32 and/or the actuator 34, especially relevant when a quick control is necessary.

The use of a plurality of actuation control devices 30, in which each actuation control device 30 is configured for controlling one of a plurality of motors 32 and/or one of a plurality of actuators 34 based on a generated analog controlling signal is especially advantageous for a more precise control of the high lift system.

The control module 48 being configured for controlling a blocking of the actuation arrangements 24 based on the generated analog controlling signal is especially advantageous to prevent uncontrolled movement of the moveable surface 20, for example upon slat/flap skew.

The braking of the movement of the at least one moveable surface 20 is also contributing to this advantageous technical effect.

The use of power off brake and of a blocking signal being a power-off signal is especially advantageous for blocking the moveable surface 20 in case of power supply failure.

Generating an analog controlling signal corresponding to a blocking signal when the acquired analog sensed signal is representative of a skew of the high lift system 16 is especially relevant to quickly prevent excessive skew of the high lift system 16.

The use of a sensor 26 being part of an asymmetry position pick off unit, of a feedback position pick off unit, a wing tip brake unit and/or the actuation arrangement ensure acquiring a meaningful analog sensed signal.

The acquisition of a command from the flight control computer 28 and the sending of the generated analog controlling signal based on the acquired command ensures to be able to control effectively the high lift system 16 from the flight control computer 28.

The communication module 50 being configured to communicate a digitalized controlling signal representative of the generated analog controlling signal to the flight control computer 28 ensures the increase the situational awareness of the flight control computer 28.

The use of an actuation control device 30 comprising a first C1 and second C2 circuitry as above mentioned is especially relevant to ensure reliability of the high lift system architecture 22.

### Reference signs:

- 10: aircraft
- 12: fuselage
- 14: wing
- 16: high lift system
- 18: wing body
- 20: moveable surface
- 22: high lift system architecture
- 24: actuation arrangement
- 26: sensor
- 28: flight control computer
- 30: actuation control device
- 32: motor
- 34: actuator
- 36: transmission shaft
- 38: brake
- 38a: wing tip brake
- 38b: motor brake
- 40: power control unit
- 41: databus
- 42: acquisition module
- 44: processing module
- 46: conversion module
- 48: control module
- 50: communication module
- 51: connection cable
- C1: first circuitry
- C2: second circuitry

## Claims

1. High lift system architecture (22) for an aircraft (10), comprising:
- an actuation arrangement (24), configured to move at least one moveable surface (20) of the aircraft (10) between a stowed and a deployed configuration;
- a sensor (26), configured to generate an analog sensed signal representative of a configuration of the moveable surface (20);
- a flight control computer (28); and
- an actuation control device (30), connected to the actuation arrangement (24), to the sensor (26) and to the flight control computer (28), the actuation control device (30) comprising:
+ an acquisition module (42), configured for acquiring the analog sensed signal from the sensor (26),
+ a processing module (44), configured for processing the analog sensed signal and for generating an analog controlling signal based on the processed analog sensed signal,
+ a conversion module (46), configured for converting the analog sensed signal into a digitalized monitoring signal,
+ a control module (48), configured for controlling the actuation arrangement (24) based on the generated analog controlling signal, and
+ a communication module (50), configured for communicating the digitalized monitoring signal to the flight control computer (28).

2. High lift system architecture (22) according to claim 1, wherein the actuation arrangement comprises a motor (32) and an actuator (34) connected to the motor (32), the actuator (34) being configured for converting movement of the motor (32) to a movement of the at least one moveable surface (20),
the control module (48) being configured for controlling the motor (32) and/or the actuator (34) based on the generated analog controlling signal.

3. High lift system architecture (22) according to claim 1 or 2, wherein the actuation arrangement (24) comprises a plurality of motors (32) and a plurality of actuators (34), the high lift system architecture (22) further comprising a plurality of actuation control devices (30), each actuation control device (30) being connected to one of the plurality of motors (32) and/or to one of the plurality of actuators (34), the control module (48) of each actuation control device (30) being configured for controlling said one of the plurality of motors (32) and/or said one of the plurality of actuators (34) based on the generated analog controlling signal.

4. High lift system architecture (22) according to any of the preceding claims, wherein the processing module (44) is configured for generating an analog controlling signal corresponding to a blocking signal, the control module (48) being configured for controlling a blocking of the actuation arrangement (24) based on the generated analog controlling signal.

5. High lift system architecture (22) according to claim 4, wherein the actuation arrangement (24) comprises at least one brake (38), configured for blocking movement of the at least one moveable surface (20),
the control module (48) being configured for controlling the at least one brake (38) based on the generated analog controlling signal corresponding to a blocking signal.

6. High lift system architecture (22) according to claim 5, wherein the brake (38) is a power off brake, the generated analog controlling signal corresponding to a blocking signal being a power-off signal.

7. High lift system architecture (22) according to any of the claims 4 to 6, wherein the processing module (44) is configured for generating an analog controlling signal corresponding to a blocking signal when the acquired analog sensed signal is representative of a skew of the high lift system (16).

8. High lift system architecture (22) according to any of the preceding claims, wherein the sensor (26) is part of an asymmetry position pick off unit, of a feedback position pick off unit, a wing tip brake unit and/or the actuation arrangement (24).

9. High lift system architecture (22) according to any of the preceding claims, wherein the acquisition module (42) is further configured for acquiring a command from the flight control computer (28), the control module (48) being configured for sending the generated analog controlling signal to the actuation arrangement (24) based on the acquired command.

10. High lift system architecture (22) according to any of the preceding claims, wherein the communication module (50) is configured to communicate a digitalized controlling signal representative of the generated analog controlling signal to the flight control computer (28).

11. High lift system architecture (22) according to any of the preceding claims, wherein the actuation control device (30) comprises a first circuitry (C1) and a second circuitry (C2), different from the first circuitry (C2), at least one of the acquisition module (42), the processing module (44), the conversion module (46), the control module (48) and the communication module (50) being redundant and implemented on both the first (C1) and the second (C2) circuitry.

12. High lift system (16) comprising a wing body (18), a moveable surface (20) and a high lift system architecture (22) according to any of the claims 1 to 11.

13. High lift system (16) according to claim 12, wherein the moveable surface (20) is a slat.

14. Aircraft (10) comprising a high lift system (16) according to claim 12 or 13.

15. Method of operating a high lift system architecture (22) according to any of the claims 1 to 11, wherein the method comprises the following steps:
- acquiring an analog sensed signal from the sensor (26) of the high lift system architecture (22);
- processing the analog sensed signal and generating an analog controlling signal based on the processed analog sensed signal;
- converting the analog sensed signal into a digitalized monitoring signal;
- controlling the actuation arrangement (24) of the high lift system (16) based on the generated analog controlling signal; and
- communicating the digitalized monitoring signal to the flight control computer (28) of the high lift system architecture (22).
